Europäisches Patentamt

European Patent Office

Office européen des brevets

(19)

(11) Veröffentlichungsnummer: **0 163 175 B1**

(12)

# EUROPÄISCHE PATENTSCHRIFT

(45) Veröffentlichungstag der Patentschrift: **29.08.90**

(51) Int. Cl.⁵: **H 03 K 3/037**

(21) Anmeldenummer: **85105601.0**

(22) Anmeldetag: **07.05.85**

(54) Breitbandfrequenzteiler.

(30) Priorität: **16.05.84 DE 3418206**

(43) Veröffentlichungstag der Anmeldung:
**04.12.85 Patentblatt 85/49**

(45) Bekanntmachung des Hinweises auf die
Patenterteilung:
**29.08.90 Patentblatt 90/35**

(84) Benannte Vertragsstaaten:
**AT DE FR GB IT NL**

(56) Entgegenhaltungen:
DE-A-2 741 205
FR-A-2 201 584
ELECTRONIC ENGINEERING, Band 51, Nr. 629,
Oktober 1979, Seiten 84-90, London, GB; S.
HOLLOCK: "A ULA family for subnanosecond
system design"
ELEKTRIE, Band 27, Nr. 3, 1973, Seiten 151-154,
Berlin, DD; E. BITTNER: "Erweiterte
Elementarschaltungen (Speicher-, Trigger-,
Start-stop-Schaltungen)", Seite 152: "1.2.
Dynamische Speicher"

(73) Patentinhaber: **Siemens Aktiengesellschaft
Wittelsbacherplatz 2
D-8000 München 2 (DE)**

(72) Erfinder: **Wilhelm, Wilhelm, Dipl.-Ing.
Geigenbergerstrasse 23
D-8000 München 71 (DE)**
Erfinder: **Incecik, Zafer, Dr.-Tech.
Balanstrasse 69
D-8000 München 90 (DE)**

EP 0 163 175 B1

**Beschreibung**

Die vorliegende Erfindung betrifft einen Frequenzteiler für digitale Schaltungen nach dem Oberbegriff des Patentanspruchs 1.

Frequenzteiler dienen in der Digitaltechnik zur Halbierung der Frequenz eines Eingangssignals, z.B. eines Taktsignals, folglich bei mehreren seriellen Funktionselementen zur Reduktion der Frequenz des Eingangssignals um die entsprechende Zweierpotenz. Mit der klassischen bipolaren Frequenzteilerschaltung lassen sich, eine Herstellungstechnologie nach dem Stand der Technik vorausgesetzt, maximale Teilerfrequenzen von etwa 1 GHz erzielen. Bei höheren Frequenzen dominieren parasitäre Laufzeiteffekte, so daß zu ihrer Verarbeitung beträchtlich höhere Anforderungen an die Technologie zu stellen sind.

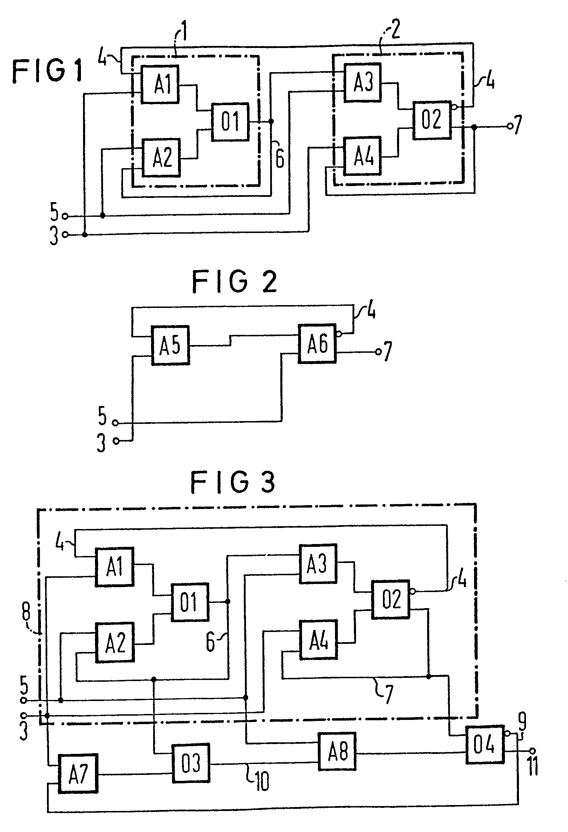

Das mit Gattersymbolen in Fig. 1 vereinfacht dargestellte Beispiel einer klassischem (statischen) Frequenzteilerschaltung nach dem Stand der Technik beruht auf einem D-Master-Slave-Flipflop. Darunter versteht man eine taktgesteuerte bistabile Kippschaltung, die zur Speicherung einer logischen Variablen dient und die demzufolge nur einen einzigen Dateneingang (Name "D") besitzt. Die als ein einziges Flipflop aufzufassende Schaltung besteht aus zwei miteinander verknüpften Flipflops; das erste Flipflop ("Master") mit dem Dateneingang bestimmt stets den Zustánd des zweiten Flipflops ("Slave") mit dem Datenausgang. Das D-Flipflop hat die Aufgabe, die an seinem Dateneingang jeweils anliegende binäre Information erst beim Eintreffen des nächsten Taktsignals am Ausgang wirksam werden zu lassen und bis zum Eintreffen des darauf folgenden Taktsignals zu speichern. Eine Frequenzteilung liegt vor, wenn man das inverse Ausgangssignal auf den Dateneingang rückkoppelt: der Ausgangszustand ändert sich dann mit jeder Steuertaktflanke.

In der Schaltung nach Fig. 1 enthält der Master 1 die AND-Gatter Al und A2, die vom inversen Taktsignal 3 und dem Umlaufsignal 4 bzw. dem Taktsignal 5 und dem Speichersignal 6 angesteuert werden und das deren Ausgänge zusammenfassende OR-Gatter 01, dessen Ausgangssignal das in der Speicherschleife rückgekoppelte Signal 6 ist. Der Slave 2 ist entsprechend aufgebaut: Die AND-Gatter A 3 und A 4 werden von den Signalen 5 und 6 bzw. 3 und dem Speichersignal 7 angesteuert und ihre Ausgangssignale mit dem OR-Gatter 02 zusammengefaßt. Dessen Ausgangssignal 7 wird gleichzeitig in der Speicherschleife, sein inverses Signal 4 in der Umlaufschleife auf den Dateneingang rückgekoppelt. Vom Taktsignal 5 gesteuert wird das die halbe Taktfrequenz besitzende Umlaufsignal 4 abwechselnd durchgeschaltet oder in der Umlaufschleife festgehalten.

Das Ausgangssignal 6 des Masters 1 wird aus dem Umlaufsignal 4 und dem Signal 6 gleichgewichtet gebildet. Im Betriebsfall eilt das Signal 6 dem Signal 4 um 90° — entsprechend der Hälfte der Taktfrequenz — nach. Gleiches gilt mit den Signalen 7 und 6 für den Slaveteil der Schaltung.

Die maximale Teilerfrequenz wird im wesentlichen von der Resonanzfrequenz der Teilerschaltung, d.h. der halben maximalen Teilerfrequenz, bestimmt. Den Resonanzkreis kann man sich als eine Art Ringoszillator, bestehend aus 4 Stufen, vorstellen. Nach Fig. 1 besteht jede Stufe aus einem oder zwei Verknüpfungsgliedern, deren je zwei Eingangssignale eine Phasendifferenz von einer Viertelperiode besitzen. Im Resonanzfall muß das nacheilende Eingangssignal dem Ausgangssignal entsprechen. Für die Verzögerung des Mischsignals, z.B. der Signale 4 und 6 zum Ausgangssignal 6, steht somit nur eine Achtelperiode bzw. ein Viertel der Taktfrequenz zur Verfügung. Stehen, wie mit modernen Bipolartechniken erreichbar, Gatter mit 250 ps Laufzeit zur Verfügung, dann beträgt die maximale Teilerfrequenz 1 GHz.

Die maximale Teilerfrequenz läßt sich mindestens verdoppeln, wenn man die Speicherschleifen mit den nacheilenden Signalen 6 und 7 entfernt und statt dessen die Gatterlaufzeit zur Verzögerung der Signale ausnutzt. Den dann erhaltenen dynamischen Frequenzteiler zeigt, vereinfacht mit Gattersymbolen dargestellt, Fig. 2 als Beispiel.

Die beiden Eingänge eines ersten AND-Gatters A 5 bilden das inverse Taktsignal 3 und das inverse Ausgangssignal 4, das Umlaufsignal. Das Ausgangssignal des Gatters A5 liegt zusammen mit dem Taktsignal 5 am Eingang des AND-Gatters A6, dessen Ausgangssignal 7 im Bereich der Resonanzfrequenz die halbe Frequenz des Taktsignals 5 besitzt.

Da beim dynamischen Teiler nach Fig. 2 die Trägheit der Gatter selbst zur Zwischenspeicherung des Umlaufsignals 4 ausgenutzt wird, bestimmt die Gatterlaufzeit den Frequenzbereich der Teilerfrequenz: Oberhalb der Maximalfrequenz ist die Gatterlaufzeit zu groß und unterhalb der Minimalfrequenz ist die Gatterlaufzeit zu gering. Beide Grenzfrequenzen liegen relativ nahe an der inversen Gatterlaufzeit. Dynamische Teiler sind deshalb für viele Anwendungsfälle nicht brauchbar.

Der vorliegenden Erfindung liegt die Aufgabe zugrunde, bei gleicher Technologie durch schaltungstechnische Maßnahmen eine gegenüber der klassischen Frequenzteilerschaltung mindestens verdoppelte maximale Teilerfrequenzbandbreite zu ereichen.

Diese Aufgabe wird bei einer Anordnung der eingangs genannten. Art erfindungsgemäß durch die Merkmale des Kennzeichens des Patentanspruchs 1 gelöst.

Eine Ausgestaltung des vorstehend definierten Erfindungsgedankens ist im Unteranspruch gekennzeichnet.

Zur Erlauterung der Erfindung dienen vier Figuren, von denen die bereits erklärten ersten beiden Figuren den Stand der Technik wiedergeben.

Fig. 1 zeigt ein Beispiel einer mit Gattersymbolen dargestellten Schaltung eines statischen Frequenzteilers nach dem Stand der Technik,

Fig. 2 zeigt ein Beispiel einer mit Gattersymbolen dargestellten Schaltung eines dynamischen Frequenzteilers nach dem Stand der Technik,

Fig. 3 zeigt eine als Ausführungsbeispiel anzusehende, mit Gattersymbolen dargestellte erfindungsgemäße Schaltung eines Frequenzteilers mit hoher Bandbreite und

Fig. 4 zeigt einen als Ausführungsbeispiel zu wertenden Stromlaufplan einer erfindungsgemäßen Frequenzteilerschaltung mit hoher Bandbreite.

Grundgedanke der vorliegenden Erfindung ist es, die Eigenschaften der beiden Frequenzteiler so zu einem breitbandigen Frequenzteiler zu kombinieren, daß dieser im niederfrequenten Breich wie ein klassischer statischer und im hochfrequenten Bereich wie ein schneller dynamischer Frequenzteiler wirkt. Fig. 3 zeigt ein mit Gattersymbolen dargestelltes Ausführungsbeispiel einer erfindungsgemäßen Schaltung.

Die Frequenzteilerschaltung enthält einen statischen Teil 8, der mit der Schaltung nach Fig. 1 weitgehend übereinstimmt. Zur Verdeutlichung tragen gleiche Elemente wie in Fig. 1 die gleichen Bezugszeichen. Der Unterschied besteht darin, daß das Ausgangssignal 7 des OR-Gatters 02 nicht mehr gleichzeitig das Ausgangssignal der Teilerschaltung ist, sondern wie in Fig. 1 in einer Speicherschleife nur noch zum einen Eingang des AND-Gatters A4 führt. Der dynamische Teil der Schaltung ist derart an den statischen Teil 8 angeschlossen, daß die Synchronisierung durch eine Verknüpfung der Masterund Slave-Signale beider Teilschaltungen erfolgt. Der "Master" des dynamischen Teils besteht aus einem AND-Gatter A7, dessen eines Eingangssignal das inverse Taktsignal 3, dessen anderes Eingangssignal das rückgekoppelte inverse Ausgangssignal 9 darstellt, und dem nachfolgenden OR-Gatter 03, das das Ausgangssignal des Gatters A7 und das Ausgangssignal 6 des statischen Masters zusammenfaßt. Sein Ausganssignal 10 stellt ein Eingangssignal des AND-Gatters A8 dar. Das Ausgangssignal des Gatters A8, dessen zweites Eingangssignal der Takt 5 ist, wird mit dem Ausgangssignal 7 des statischen Teilers 8 durch das OR-Gatter 04 zum Ausgangssignal 11 zusammengefaßt.

Die Synchronisierung des dynamischen Schaltungsteils mit dem statischen mit Hilfe der OR-Gatter 03 und 04 gewährleistet beim Ausbleiben der Signale des statischen Teils 8 bei der Überschreitung seiner Grenzfrequenz den fehlerfreien Übergang zum dynamischen Teil und umgekehrt.

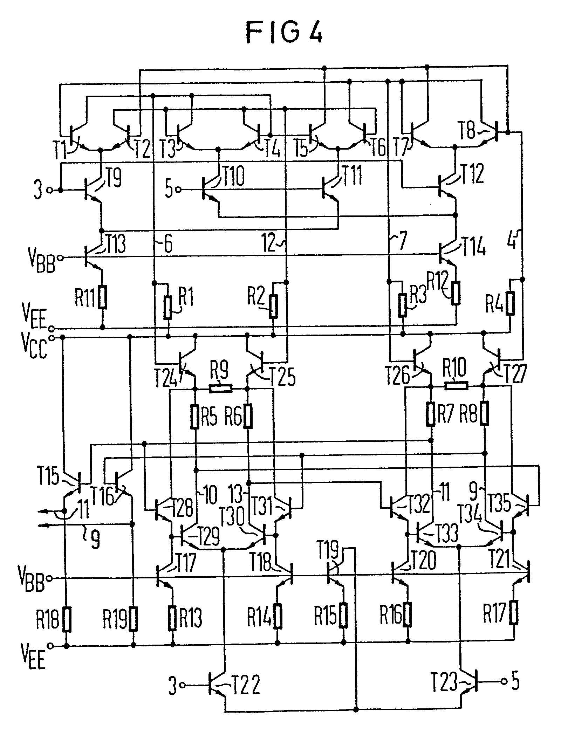

Von den Möglichkeiten zur Realisierung des Prinzipschaltbildes nach Fig. 3 zeigt Fig. 4 einen als Ausführungsbeispiel aufzufassenden Stromlaufplan einer erfindungsgemäßen Frequenzteilerschaltung.

Die Schaltung nach Fig. 4 arbeitet mit den komplementären Signalen 6 und 12 bzw. 7 und 4 im statischen Teil und 10 und 13 bzw. 11 und 9 im dynamischen Teil, die jeweils die Eingänge von Signaldifferenzverstärkerstufen ansteuern. Die komplementären Taktsignale 5 und 3 liegen entsprechend an den Eingängen von Differenzverstärkerstufen, deren Ausgänge jeweils mit den Emittern einer Signaldifferenzstufe verbunden sind. Die sich somit ergebende Serienschaltung stellt jeweils ein AND- bzw. ein komplementäres NAND-Gatter dar. Die Emitterwiderstände der Taktdifferenzverstärker sind durch Stromquellen ersetzt. Gleiche Stromquellen enthalten auch emitterfolger-gesteuerte Stromschalter im dynamischen Teil des Frequenzteilers, an deren Eingängen die Komplementärsignale 11 und 9 bzw. 10 und 13 liegen und deren Ausgänge gleichzeitig die Eingänge der zugehörigen Differenzverstärker bilden. Die Stromschalter erhöhen zusätzlich die für den dynamischen Teiler charakteristische Resonanzfrequenz und damit die obere Grenzfrequenz der Gesamtschaltung.

Wesentlich für die Fuktion der Gesamtschaltung ist eine Synchronisierschaltung zwischen beiden Teilen, die genügend Einfluß auf den dynamischen Teiler hat, gleichzeitig aber keine bzw. keine wesentliche zusätzliche Verzögerung des dynamischen Schaltungsteils verursacht. Dazu werden die komplementären Signale 6 und 12 bzw. 7 und 4 des statischen Teilers über Emitterfolger in den dynamischen Teiler eingespeist. Die Verknüpfung der entsprechenden digitalen Signale beider Teilschaltungen erfolgt durch eine analoge Spannungsaddition an den Emitterwiderständen, die zugleich zur Lastimpedanz gehören und mit ihrer induktiven Komponente zur Beschleunigung beitragen. Die über Emitterfolger ausgekoppelten Komplementärsignale 11 und 9 bilden die Ausgangssignale des Frequenzteilers.

Da jeder Schaltungsteil aus zwei gleich aufgebauten Funktionsgruppen besteht, genügt die Beschreibung je einer dieser Funktionsgruppen und die Angabe der entsprechend zugeordneten Bauelemente in Klammern. Alle Transistoren sind vom npn-Typ.

Beim Master 1 (Slave 2) des statischen Teils der Schaltung liegt das Taktsignal 5 an der Basis des Transistors T10 (T11), das inverse Taktsignal 3 an der Basis des Transistors T9 (T12). T9 und T11 bzw. T10 und T12 bilden Differenzstufen, in deren Emitterzweig je eine Stromquelle liegt, die die Transistoren T13 und T14 enthält. Die Emitter dieser Transistoren sind über die Widerstände R11 und R12 mit dem Pol $V_{EE}$ der Versorgungsspannungsquelle, die Basen mit der Hilfsspannung $V_{BB}$ und die Kollektoren mit der Last, den Emittern von T9 und T11 bzw. T10 und T12 verbunden. Der Kollektor des Transistors T9 (T11) ist mit den Emittern der aus T1 und T2 (T5 und T6) gebildeten Differenzstufe verbunden, die von den Komplementärsignalen 7 und 4 (6 und 12) angesteuert werden, die ihrerseits an den Kollektoren der Transistoren T6 und T5 (T1 und T2) abzugreifen sind.

Der Kollektor des Transistors T10 (T12) ist mit den Emittern der aus T3 und T4 (T7 und T8) gebildeten Differenzstufe verbunden, die von den Komplementärsignalen 12 und 6 (7 und 4) angesteuert werden. An den Kollektoren sind die jeweils inversen Eingangssignale, d.h. 6 und 12 (4 und 7) abzugreifen.

Die Kollektoren von T1 und T3 (T6 und T8) bzw. gleichbedeutend, die Basen von T4 und T5 (T7 und T1) sind über den Widerstand R1 (R3) mit dem Pol $V_{CC}$ der Versorgungsgleichspannungsquelle verbunden. Die Kollektoren von T2 und T4 (T5 und T7) bzw. gleichbedeutend, die Basen von T3 und T6 (T8 und T2) sind über den Widerstand R2 (R4) mit dem Pol $V_{CC}$ der Versorgungsgleichspannung verbunden.

Die Transistoren T2 und T9 bzw. T4 und T10 bilden mit der Umkehrstufe T3 die AND-Gater Al bzw. A2, die Transistoren T5 und T11 bzw. T7 und T12 mit der Umkehrstufe T8 die AND-Gatter A3 bzw. A4. Die OR-Gatter 01 und 02 werden durch die Kollektoranschlüsse von T1 (T6) und der Inverterstufe T3 (T8) realisiert.

Ein Taktsignal 5 an T10 und T11 steuert die AND-Gatter A2 und A3 durch, sperrt T3 und T6 bzw. T2 und T8 und bereitet die Basen von T1 und T7 vor, die beim inversen Taktsignal 3 durchsteuern. T6 und T8, die ausgangsseitig parallel liegen, sperren weiterhin; die Signale 7 bzw. 4 ändern sich nicht. Mit T1 kippen dagegen die Signale 6 bzw. 12; letzteres bereitet T3 und T6 auf das nächste Taktsignal 5 vor, während T4 und T6 sperren. Beim Durchschalten der Takttransistoren T10 und T11 kippen T3 und T6 ebenfalls und invertieren die Signale 7 bzw. 4, während 6 bzw. 12 sich nicht ändern. Damit sperren neben T4 und T5 auch T1 und T7, während T2 und T8 für den inversen Takt 3 vorbereitet werden, der die Signale 7 bzw. 4 unverändert läßt und 6 bzw. 12 invertiert. Das Spiel wiederholt sich entsprechend mit den Taktänderungen, wobei sich die Signale 6 bzw. 12 und 7 bzw. 14 mit halber Taktfrequenz ändern.

Im dynamischen Teil der Frequenzteilerschaltung bilden die Transistoren T22 und T23 eine Differenzstufe. Die Emitter beider Transistoren sind miteinander und mit einer Stromquelle, d.h. dem Kollektor von T19 verbunden, dessen Emitter über den Widerstand R15 am Pol $V_{EE}$ der Versorgungsspannungsquelle und an dessen Basis die Hilfsspannung $V_{BB}$ liegt. Die komplementären Taktsignale 3 und 5 steuern die Eingänge der Differenzstufe an, wobei das Signal 3 (5) an der Basis von T22 (T23) liegt. Die Ausgänge der Stufe liegen je im Emitterzweig einer weiteren Differenzverstärkerstufe. Dabei ist der Kollektor von T22 (T23) mit den Emittern von T29 und T30 (T33 und T34) verbunden. Die Basen der Transistoren werden über emitterfolger-gesteuerte Stromschalter angesteuert. Deren jeweils identische Stromquellen bestehen aus den Transistoren T17 und T18 (T20 und T21), deren Emitter über die Widerstände R13 und R14 (R16 und R17) am Pol $V_{EE}$ der Versorgungsspannungsquelle liegen und an deren Basen die Hilfsspannung $V_{BB}$ angeschlossen ist. Die Kollektoren sind mit den Ausgängen der Emitterfolger T28 und T31 (T32 und T35) und den Basen von T29 und T30 (T33 und T34) verbunden.

An den Basen von T28 und T31 (T32 und T35)

liegen die Komplementärsignale 11 und 9 (13 und 10), die an den Kollektoren von T33 und T34 (T30 und T29) abgegriffen werden. Die Kollektoren der Emitterfolger sind ihrerseits mit den Ausgängen weiterer Emitterfolger T24 und T25 (T26 und T27) verbunden, deren Kollektoren am Pol $V_{CC}$ der Gleichspannungsquelle liegen und über deren Basen die Signale 6 und 12 (7 und 4) des statischen Teilers eingespeist werden. Die Emitter von T24 und T25 (T26 und T27) sind über den Widerstand R9 (R10) miteinander und über die Widerstände R5 und R6 (R7 und R8), die Summationswiderstände für die statischen und dynamischen Teilersignale, mit den Kollektoren von T29 und T30 (T33 und T34) verbunden.

Die Kollektoren von T33 und T34 führen weiterhin zu den Basen der Ausgangs-Emitterfolger T1 und T16, deren Kollektoren mit dem Pol $V_{CC}$ und deren über die Widerstände R18 und R19 mit dem Pol $V_{EE}$ der Versorgungsspannungsquelle verbunden sind. An den Emittern lassen sich die Ausgangssignale 9 und 11 abgreifen.

Die Transistoren T22 und T30 bzw. T23 und T34 entsprechen den AND-Gattern A7 bzw. A8. Zusätzliche Inverterstufen sind, da jeweils komplementäre Signale zur Verfügung stehen, beim erfindungsgemäßen Ausführungsbeispiel nicht notwendig. Aus diesen Grund und wegen der Stromschaltertechnik, die eine Sättigung der entsprechenden Transistoren vermeidet, weil ihr Basispotential nicht positiver als das Kollektorpotential werden kann, verkürzt sich die die maximale Teilerfrequenz bestimmende, zur Zwischenspeicherung herangezogene Gatterlaufzeit entscheidend. Die komplementären Signalpakete 9 und 11 bzw. 10 und 13 pendeln mit halber Taktfrequenz zwischen den Transistorgruppen T28 bis T31 und T32 bis T35 hin und her. Die maximale Teilerfrequenz der erfindungsgemäßen Schaltung nach Fig. 4 beträgt 2,4 GHz. Phasenprobleme bei der Synchronisierung beider Teilschaltungen treten nicht auf, weil diese jeweils von den gleichen Taktsignalen gesteuert werden.

## Patentansprüche

1. Frequenzteiler in Bipolartechnik mit einem taktgesteuerten, zwischen inversem Ausgang und Dateneingang rückgekoppelten D-Master-Slave-Flipflop (8) als statische Teilschaltung, wobei dessen Master-Flipflop (1) und dessen Slave-Flipflop (2) jeweils Rückführschleifen zwischen Ausgang und Eingang zur Zwischenspeicherung aufweisen und mit einem weiteren taktgesteuerten D-Master-Slave-Flipflop ohne Rückführschleifen als dynamische Teilschaltung, dadurch gekennzeichnet, daß die Rückführschleifen des D-Master-Slave-Flipflop (8) der statischen Teilschaltung mit den entsprechenden Ausgängen des D-Master-Slave-Flipflops (A7, A8) der dynamischen Teilschaltung gekoppelt sind, und die Verknüpfung der Ausgänge der Slave-Flipflop als Ausgang des Frequenzteilers vorgesehen ist.

2. Frequenzteiler nach Anspruch 1, dadurch gekennzeichnet, daß die Kopplung von statischer und dynamischer Teilschaltung über Emitterfolger (T24 bis T27) durch Spannungsaddition der jeweiligen Signale beider Teilschaltungen an Widerständen (R5 bis R10) erfolgt.

## Revendications

1. Diviseur de fréquence réalisé selon la technique bipolaire et comportant une bascule bistable maître-esclave de type D (8), commandée de façon cadencée et couplée par réaction entre sa sortie inverse et l'entrée des données, et qui forme un circuit partiel statique et dont la bascule bistable maître (1) et la bascule bistable esclave (2) comportent respectivement des boucles de réaction entre la sortie et l'entrée pour réaliser une mémorisation temporaire, et une autre bascule bistable maître-esclave de type D, commandée de façon cadencée, ne comportant aucune boucle de réaction et utilisée en tant que circuit partiel dynamique, caractérisé par le fait que les boucles de réaction de la bascule bistable maître-esclave de type D (8) du circuit partiel statique sont couplées aux sorties correspondantes de la bascule bistable maître-esclave de type D (A7, A8) du circuit partiel dynamique, et la jonction des sorties des bascules bistables esclaves est prévue en tant que sortie du diviseur de fréquence.

2. Diviseur de fréquence suivant la revendication 1, caractérisé par le fait que le couplage du circuit partiel statique et du circuit partiel dynamique est réalisé au moyen d'émetteurs suiveurs (T24 à T27), par addition des signaux respectifs de deux circuits partiels aux bornes de résistances (R5 et R10).

## Claims

1. Bipolar frequency divider having a clock-controlled fed-back D-master-slave flip-flop (8) between inverted output and data input, as a static subcircuit, its master flip-flop (1) and its slave flip-flop (2) having in each case feedback loops between output and input for interim storage and having a further clock-controlled D-master-slave flip-flop without feedback loops as a dynamic subcircuit, characterized in that the feedback loops of the D-master-slave flip-flop (8) of the static subcircuit are coupled to the corresponding outputs of the D-master-slave flip-flop (A7, A8) of the dynamic subcircuit and the logical connection of the outputs of the slave flip-flop is provided as output of the frequency divider.

2. Frequency divider according to Claim 1, characterized in that the coupling of static and dynamic subcircuit via emitter followers (T24 to T27) occurs via voltage addition of the respective signals of both sub-circuits at resistors (R5 to R10).

FIG 1

FIG 2

FIG 3

FIG 4